# EUROPÄISCHE PATENTANMELDUNG

(11) **EP 0 955 552 A1**
(43) Veröffentlichungstag der Anmeldung: **10.11.1999**
(21) Anmeldenummer: 99108206.6
(22) Anmeldetag: 27.04.1999
(51) Int. Cl.: G01R 31/34

(54) **Verfahren zum Erkennen von Fehlern in einem Gleichstromkommutatormotor**

(30) Priorität: 07.05.1998 DE 19820313
(71) Anmelder: Bayerische Motoren Werke Aktiengesellschaft, 80788 München (DE)
(72) Erfinder: Iamandi, Heiko, 80993 München (DE)

(57) **Zusammenfassung**

Bei einem Verfahren zum Erkennen von Fehlern in einem Gleichstromkommutatormotor wird der durch den Anker fließende Strom hinsichtlich seiner Signalform mit dem Stromsignal eines fehlerfreien Motors verglichen. Bei einer charakteristischen Abweichung der beiden Signalformen wird auf einen Fehler erkannt.

## Beschreibung

Die Erfindung bezieht sich auf ein Verfahren zum Erkennen von Fehlern in einem Gleichstromkommutatormotor.

Es ist bekannt, mit Hilfe des drehzahlproportionalen, auf der Versorgungsleitung anliegenden Spannungssignals die Drehzahl des Motors selbst zu bestimmen (vgl. DD 254254 A1). Dabei wird aus dem Spannungssignal eine Impulsfolge gewonnen, deren Frequenz mit der Drehzahl korreliert.

Es ist Aufgabe der Erfindung, ein Verfahren der eingangs genannten Art zu schaffen, bei dem es möglich ist, einen eventuellen Fehler des Gleichstromkommutatormotors während seines Betriebs, d. h. in der Regel noch lange vor dem Totalausfall des Motors zu erkennen.

Die Erfindung löst diese Aufgabe durch die Merkmale des Patentanspruchs 1.

Bei der Erfindung wird das Ankerstromsignal nicht aufbereitet, um beispielsweise eine drehzahlproportionale Impulsfolge daraus zu gewinnen. Es wird vielmehr im Originalzustand dazu verwendet, einen Fehler des Motors zu erkennen. Das ist insbesondere dann von Bedeutung, wenn es sich dabei um einen schleichenden Fehler handelt, der die Funktion des Motors nach außen hin noch gar nicht beeinträchtigt. Durch das Signalbild des Stromes läßt sich bereits in einem sehr frühen Stadium der Fehler erkennen und eine Abschätzung vornehmen, in welcher Weise die Lebensdauer des Motors bzw. die Funktionalität tatsächlich beeinträchtigt ist und/oder wie beispielsweise die Betriebsweise des Motors verändert werden muß, um einen Totalausfall zu vermeiden.

Die Ausgestaltungen der Erfindung, die die Erkennungssicherheit noch weiter erhöhen, sind Gegenstand der Patentansprüche 2 und 3. Sie ermöglichen es, einen eventuellen Fehler noch exakter zu erkennen.

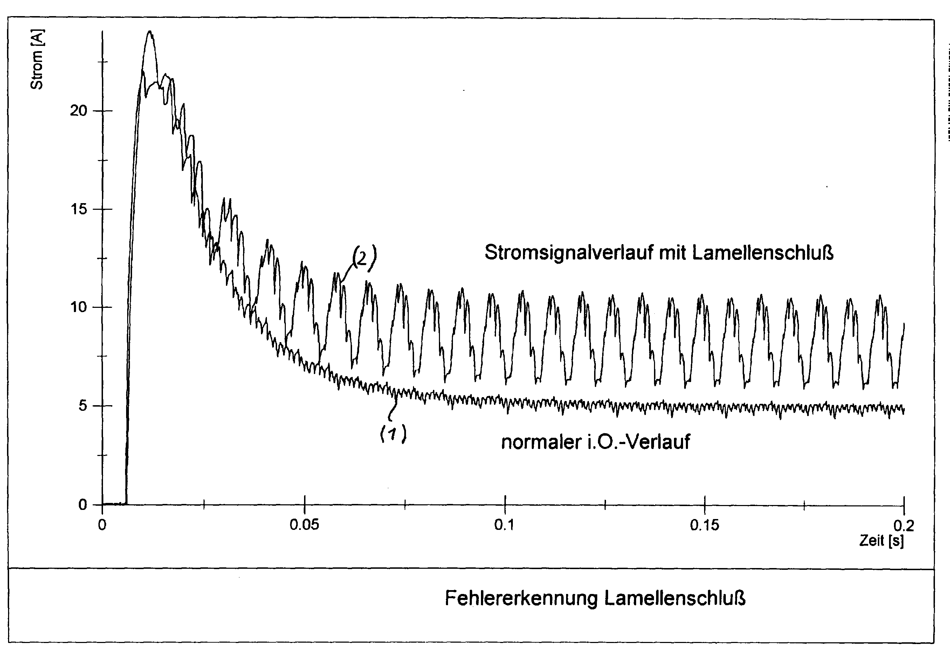

Anhand der einzigen Figur sind die Signalbilder eines fehlerfreien Gleichstromkommutatormotors (Bild (1)) und eines mit Windungsschlüssen versehenen, fehlerbehafteten aber dennoch funktionsfähigen Motors (Bild (2)) dargestellt.

Bestimmte Fehler des Gleichstrommotors sind anhand von charakteristischen Signalverläufen identifizierbar. So zeigen sich bei Windungsschlüssen, verursacht durch thermische Schädigung der Ankerwicklung, je nach Fortschreiten dieses Fehlerbildes mehr oder minder stark ausgeprägte Stromspitzen. Die thermische Schädigung ist ein typischer Vertreter eines fortschreitenden Fehlers. Proportional zum Grad der unzulässigen Wicklungserwärmung werden immer mehr Ankerwicklungen (Ankerwindungen) durch Schädigung der Drahtisolation kurzgeschlossen und damit der Wicklungswiderstand verringert. Durch den Kommutierungsvorgang entstehen auf der Stromversorgungsleitung des Gleichstromkommutatormotors Stromrippel, deren Signalbild im Vergleich mit dem des fehlerfreien Motors eine eindeutige Aussage über die Fehlerquelle, die Fehlerart und sogar die voraussichtliche Lebensdauer des Motors erlauben. Entsprechend der Schädigung der Drahtisolation treten immer häufiger auffällig hohe Stromrippel auf, die im Extremfall in der Höhe des Kurzschlußstromes liegen. Ein ähnliches, wenn auch in der Höhe der Stromspitze nicht so stark ausgeprägtes Verhalten zeigt auch ein Lamellenschluß.

Zur Unterscheidung von Ankerwindungsschluß und Lamellenschluß ist dieses Verfahren bei Verwendung geeigneter mathematischer Algorithmen ebenfalls geeignet.

Der besondere Vorteil der Erfindung ist darin zu sehen, daß bereits das Signalbild einer einzigen Umdrehung des Motors eine Aussage über dessen Zustand ermöglicht. Bei entsprechender Aufbereitung des Signals und z. B. einem Vergleich mit für verschiedene Fehler charakteristischen Signalverläufen lassen sich Fehler und ihre Ursachen erkennen, lange bevor die Funktion des Motors beeinträchtigt ist. Auch läßt sich aus dem Vergleich der Signalbilder über die Betriebszeit des Motors hinweg der Verlauf eines Schadens verfolgen und es läßt sich auch erkennen, ob eine Verringerung der mechanischen Belastung des Motors die gewünschte Wirkung, nämlich eine Verlängerung der Lebensdauer des Motors zur Folge hat.

Der Vergleichsmaßstab, mittels dem ggf. ein Fehler in dem Motor erkannt wird, kann auf unterschiedliche Weise bereitgestellt werden. Eine Möglichkeit ist, mit vorgegebenen Standards zu arbeiten. Eine Verbesserung demgegenüber ergibt sich, wenn der Signalverlauf des fehlerfreien Motors selbst bei dessen Inbetriebnahme aufgezeichnet wird. Der Einfluß von Fertigungstoleranzen kann dadurch eliminiert werden. Voraussetzung dafür ist allerdings, daß der Motor selbst auch tatsächlich in Ordnung ist. Dies kann durch Vergleich mit einem Standardbild sichergestellt werden.

## Patentansprüche

1. Verfahren zum Erkennen von Fehlern in einem Gleichstromkommutatormotor, dadurch gekennzeichnet, daß der durch den Anker fließende Strom hinsichtlich seiner Signalform mit dem Stromsignal eines fehlerfreien Motors verglichen wird und bei einer charakteristischen Abweichung der beiden Signalformen auf einen Fehler erkannt wird.

2. Verfahren nach Anspruch 1, dadurch gekennzeichnet, daß das Stromsignal des fehlerfreien Motors selbst gewonnen und abgespeichert wird.

3. Verfahren nach Anspruch 1 oder 2, dadurch gekennzeichnet, daß das Stromsignal auf den jeweiligen thermischen Schädigungsgrad des Motors bezogen wird.
